# EUROPÄISCHE PATENTSCHRIFT

(11) **EP 1 175 697 B1**
(45) Veröffentlichungstag und Bekanntmachung des Hinweises auf die Patenterteilung: **13.08.2008**
(21) Anmeldenummer: 00930988.1
(22) Anmeldetag: 29.03.2000
(51) Int. Cl.: H01L 21/288, H01L 21/768, H01L 21/60, H01L 23/485

(54) **VERFAHREN ZUR HERSTELLUNG EINES KONTAKTHÖCKERS**
METHOD OF PRODUCING A CONTACT BUMP
PROCEDE DE REALISATION D'UN BOSSAGE DE CONTACT

(30) Priorität: 30.03.1999 DE 19914338
(43) Veröffentlichungstag der Anmeldung: 30.01.2002
(73) Patentinhaber: Pac Tech - Packaging Technologies GmbH, 14641 Nauen (DE)
(72) Erfinder: ZAKEL, Elke, D-14612 Falkensee (DE)
(74) Vertreter: Tappe, Hartmut
(86) Internationale Anmeldenummer: PCT/DE2000/000933
(87) Internationale Veröffentlichungsnummer: WO 2000/060649

(56) Entgegenhaltungen:
- EP-A- 0 308 971
- DE-A- 19 631 565
- US-A- 5 182 006
- PATENT ABSTRACTS OF JAPAN vol. 014, no. 133 (E-0902), 13. März 1990 (1990-03-13) -& JP 02 002132 A (NEC CORP), 8. Januar 1990 (1990-01-08)
- PATENT ABSTRACTS OF JAPAN vol. 1998, no. 02, 30. Januar 1998 (1998-01-30) -& JP 09 283557 A (WORLD METAL:KK), 31. Oktober 1997 (1997-10-31)
- J.AUDET ET AL: "Low Cost Bumping Process for Flip Chip" SEMICOND.TECHNOL. CENTER, 1995, Seiten 16-21, XP000933528 Pa,USA
- PATENT ABSTRACTS OF JAPAN vol. 018, no. 170 (C-1182), 23. März 1994 (1994-03-23) -& JP 05 331660 A (TOTO LTD), 14. Dezember 1993 (1993-12-14)

## Beschreibung

Die vorliegende Erfindung betrifft ein Verfahren gemäß dem Anspruch 1 zur Herstellung eines Kontakthöckers auf einer Anschlussfläche eines Halbleitersubstrats, bei dem zur Ausbildung einer Trägermetallisierung eine Bekeimung der Anschlussfläche durch elektrolytische Beaufschlagung der Anschlussfläche mit Zinkat erfolgt, derart, dass elektrolytisch auf der Anschlussfläche abgeschiedene Zinkpartikel als Keime für eine nachfolgend autokatalytisch auf der Trägermetallisierung abgeschiedene Kontaktmetallisierung dienen.

Zur Präparierung von Halbleitersubstraten für eine nachfolgende Kontaktierung ist es bekannt, die in der Regel aus Aluminium bestehenden Anschlussflächen der Halbleitersubstrate mit einer erhöhten Kontaktmetallisierung, sogenannten "Bumps", zu versehen. Insbesondere bei einer Aufbringung der Kontaktmetallisierung auf die Anschlussflächen durch eine autokatalytische Abscheidung von Metall hat es sich als notwendig herausgestellt, zur Verbesserung der Haftung des autokatalytisch abgeschiedenen Metalls auf der Anschlussfläche die Kontaktmetallisierung nicht unmittelbar auf die Anschlussfläche aufzubringen, sondern vielmehr eine Trägermetallisierung zwischen der Anschlussfläche und der Kontaktmetallisierung vorzusehen. Dies gilt in besonderem Maße, wenn die Kontaktmetallisierung aus den autokatalytisch abgeschiedenen Metallen Nickel und Gold gebildet ist.

Zur Verbesserung der Haftung zwischen den autokatalytisch abgeschiedenen Metallen und der Anschlussfläche hat es sich als vorteilhaft herausgestellt, wenn vorangehend der autokatalytischen Abscheidung eine elektrolytische Beaufschlagung der Anschlussfläche mit Zinkat erfolgt. Das Zinkat bzw. das im Zinkat enthaltene Zink scheidet sich dabei bevorzugt an den Korngrenzen des relativ grobkörnig ausgebildeten Aluminiums der Anschlussfläche ab und bildet derart eine relativ grobe Verteilung von Keimen auf der Anschlussfläche aus. Durch eine derartige Bekeimung wird zwar eine gute Haftung eines nachfolgend autokatalytisch auf der Anschlussfläche abgeschiedenen Metalls erreicht. Jedoch wird aufgrund der vorgegebenen grob verteilten Bekeimung nur ein entsprechend grobkörniges Gefüge in dem autokatalytisch abgeschiedenen Metall ausgebildet. Dieses relativ grobe Gefüge unterstützt die Ausbildung von Gefügefehlstellen, was letztendlich zu Einschränkungen in der Zuverlässigkeit derartig ausgebildeter Kontaktmetallisierungen führt.

Alternativ zur elektrolytischen Beaufschlagung der Anschlussflächen mit Zinkat ist es auch bekannt, Anschlussflächen in Vorbereitung auf eine nachfolgende autokatalytische Metallabscheidung einer elektrolytischen Beaufschlagung mit Palladium zu unterziehen. Die hierdurch erzielte Bekeimung der Anschlussfläche weist zwar eine wesentlich feinere Struktur mit vergleichsweise größerer Keimzahl auf. Hierdurch wird auch eine entsprechend feinkörnige Ausbildung des nachfolgend autokatalytisch abgeschiedenen Metallgefüges möglich. Als nachteilig im Zusammenhang mit einer Palladium-Bekeimung erweist es sich jedoch, dass Palladium aufgrund seiner ausgeprägt katalytischen Eigenschaft eine nur geringe Selektivität aufweist, so dass eine intensive Bekeimung mit Palladium zu einer Abscheidung von Palladium nicht nur auf den Anschlussflächen, sondern auch auf der gesamten Oberfläche des Halbleitersubstrats erfolgen kann. Hinzu kommt, dass durch eine Palladium-Bekeimung, insbesondere im Vergleich zu einer Zinkat-Bekeimung, nur eine geringe Haftung zu einer nachfolgend autokatalytisch abgeschiedenen Metallisierung erzielbar ist.

In der deutschen Offenlegungsschrift DE 196 31 565 A1 ist ein Verfahren beschrieben, bei dem verbesserte Kontaktmetallisierungen auf den Anschlussflächen eines Chips dadurch ausgeformt werden, dass zunächst eine die Anschlussfläche flächig bedeckende Schicht aus Zink aufgebracht wird, und anschließend die so aufgebrachte Zinkschicht mit einer flächigen Palladiumschicht überdeckt wird.

In Patent Abstracts of Japan Nr. 02002132 A ist ein Verfahren zur Ausbildung von Lotbumps beschrieben, bei dem vor der Ausbildung der Lotbumps eine die Anschlussflächen eines Chips flächig bedeckende Zwischenschicht aus einer Palladium/Zink-Legierung auf den Anschlussflächen des Chips ausgebildet wird.

In Patent Abstracts of Japan Nr. 09283557 A ist ein Verfahren beschrieben, bei dem vor der Ausbildung von Lotbumps auf den Kontaktflächen eines Halbleitersubstrats die Anschlussflächen flächig bedeckende Schichten aufgebracht werden, wobei die Schichten jeweils aus drei Lagen aus unterschiedlichen Materialien aufgebaut sind. Die drei Lagen bestehen aus einer Palladium/Metall-Legierungslage, einer Nickellage und einer weiteren Palladium/Metall-Legierungslage, wobei als Metall Zink, Blei, Arsen, Wismut, Zinn, Antimon, Tellur, Nickel, Kobalt, Kupfer, Eisen, Mangan, Gold, Quecksilber, Silber, Cadmium und Schwefel vorgeschlagen werden.

In der EP 0 308 971 A2 ist ein Verfahren beschrieben, bei dem vor der Ausbildung eines Lotbumps auf der Anschlussfläche eines Halbleitersubstrats zunächst eine die Kontaktfläche flächig bedeckende Schicht aus Palladium und darauf wiederum eine flächig ausgebildete Schicht aus Nickel aufgebracht wird.

In der US Patentschrift 5,182,006 ist ein Verfahren zur Ausbildung ebener Metallflächen auf verzinkten Aluminiumsubstraten beschrieben.

Der vorliegenden Erfindung liegt die Aufgabe zugrunde, ein Verfahren zur Herstellung eines Kontakthöckers mit einer Kontaktmetallisierung auf der Anschlussfläche eines Halbleitersubstrats vorzuschlagen, das eine weitere Verbesserung der Qualität der Kontaktmetallisierung ermöglicht.

Diese Aufgabe wird durch ein Verfahren mit den Merkmalen des Anspruchs 1 gelöst.

Bei dem erfindungsgemäßen Verfahren erfolgt neben der elektrolytischen Beaufschlagung mit Zinkat eine elektrolytische Beaufschlagung der Anschlussfläche mit Palladium, derart, dass unter Ausbildung von zinkfreien Zwischenflächen eine relativ grobe Verteilung von Zinkpartikeln auf der Anschlussfläche erzeugt wird und eine relativ feine Verteilung von Palladiumpartikeln auf den zinkfreien Zwischenflächen erfolgt, die neben den Zinkpartikeln als Keime für die nachfolgend autokatalytisch auf der Anschlussfläche abgeschiedene Kontaktmetallisierung dienen.

Diese erfindungsgemäße Kombination einer elektrolytischen Zinkat-Beaufschlagung mit einer elektrolytischen Palladium-Beaufschlagung führt zu einer hybriden Bekeimung, die zu einer auf der Anschlussfläche gut haftenden Kontaktmetallisierung mit feinkörnigem Gefüge und entsprechend glatter Oberflächenmorphologie führt. Hierdurch wird eine Kontaktmetallisierung geschaffen, die eine erhöhte Zuverlässigkeit aufweist.

Bei einer bevorzugten Variante des Verfahrens wird in einem Verfahrensschritt die elektrolytische Beaufschlagung der Anschlussfläche mit Zinkat (Zinkat-Beaufschlagung) und in einem nachfolgenden Verfahrensschritt die elektrolytische Beaufschlagung der Anschlussfläche mit Palladium (Palladium-Beaufschlagung) durchgeführt. Bei dieser Variante führt die nachfolgende Palladium-Beaufschlagung zu einer nachträglichen Verfeinerung der durch die Zinkat-Beaufschlagung vorgegebenen Bekeimungsstruktur.

Insbesondere dann, wenn die Zinkat-Beaufschlagung zumindest anteilig nachfolgend einer Palladium-Beaufschlagung erfolgt, ergibt sich der vorteilhafte Effekt, dass die durch die Zinkat-Beaufschlagung bedingte relativ hohe Ätzabtragsrate auf der Anschlussfläche durch die vergleichsweise niedrige Ätzabtragsrate des Palladiums reduziert wird. Auch dieser Effekt wirkt sich vorteilhaft auf die Oberflächenmorphologie der Kontaktmetallisierung aus, da eine noch größere Glattheit der Oberfläche der Kontaktmetallisierung erzielbar ist.

Eine Möglichkeit, diesen Effekt zu erzielen besteht darin, die Zinkat-Beaufschlagung nicht in einem Verfahrensschritt durchzuführen, sondern die Zinkat-Beaufschlagung zu unterbrechen und zwischenzeitlich eine Palladium-Beaufschlagung durchzuführen, derart, dass vorangehend der Palladium-Beaufschlagung eine zumindest teilweise Entfernung der Zinkpartikel mit anschließender erneuter Zinkat-Beaufschlagung erfolgt.

Eine weitere Möglichkeit besteht darin, in einem Verfahrensschritt die elektrolytische Beaufschlagung der Anschlussfläche mit Palladium (Palladium-Beaufschlagung) und in einem nachfolgenden Verfahrensschritt die elektrolytische Beaufschlagung der Anschlussfläche mit Zinkat (Zinkat-Beaufschlagung) durchzuführen.

Die mit der vorhergehenden Ausführungsvariante erzielbare Verfeinerung der Bekeimungsstruktur und die damit einhergehende Verfeinerung der Gefügestruktur der Kontaktmetallisierung lässt sich noch weiter steigern, indem nachfolgend der Zinkat-Beaufschlagung eine zumindest teilweise Entfernung der Zinkpartikel mit anschließender erneuter Zinkat-Beaufschlagung erfolgt.

Eine hybride Bekeimung, die gefolgt von einer autokatalytischen Metallabscheidung zu einer Kontaktmetallisierung mit besonders guter Haftung auf der Anschlussfläche bei ausgeprägt gleichmäßiger Oberflächenmorphologie der Kontaktmetallisierung führt, wird möglich, wenn in einem Verfahrensschritt eine erste elektrolytische Beaufschlagung der Anschlussfläche mit Zinkat (Zinkat-Beaufschlagung), in einem nachfolgenden Verfahrensschritt die elektrolytische Beaufschlagung der Anschlussfläche mit Palladium (Palladium-Beaufschlagung) und in einem weiteren Verfahrensschritt eine zweite Zinkat-Beaufschlagung erfolgt.

Auch bei dieser Variante lässt sich eine noch weitergehende Verbesserung der Oberflächenmorphologie der Kontaktmetallisierung erzielen, wenn nachfolgend der ersten Zinkat-Beaufschlagung und vorhergehend der Palladium-Beaufschlagung eine zumindest teilweise Entfernung der Zinkpartikel erfolgt.

Wenn die Bekeimung der Anschlussfläche in einem kombinierten Elektrolyten aus Zinkat und Palladium-Ionen erfolgt, so dass die elektrolytische Beaufschlagung der Anschlussfläche mit Zinkat (Zinkat-Beaufschlagung) und die elektrolytische Beaufschlagung der Anschlussfläche mit Palladium (Palladium-Beaufschlagung) in einem gemeinsamen Verfahrensschritt erfolgt, derart, dass die Zinkat-Beaufschlagung gleichzeitig mit der Palladium-Beaufschlagung durch den kombinierten oder gemischten Elektrolyten (Zinkat/Palladium-Beaufschlagung) erfolgt, ist eine einerseits gut haftende autokatalytisch abgeschiedene Kontaktmetallisierung mit andererseits ebenmäßiger Oberflächenmorphologie basierend auf nur einem einzigen Verfahrensschritt zur Bekeimung der Anschlussfläche erzielbar.

Eine Möglichkeit, die vorstehende Verfahrensvariante vorteilhaft abzuwandeln, besteht darin, dass nachfolgend der Zinkat/Palladium-Beaufschlagung eine zumindest teilweise Entfernung der Zinkpartikel mit anschließender erneuter Zinkat-Beaufschlagung erfolgt.

Alternativ besteht auch die Möglichkeit, vorangehend der Zinkat/Palladium-Beaufschlagung eine Zinkat-Beaufschlagung der Anschlussfläche mit anschließender zumindest teilweiser Entfernung der Zinkpartikel durchzuführen.

Als besonders vorteilhaft betreffend eine Ausführung der zumindest teilweisen Entfernung der Zinkpartikel hat sich ein Strippen der Zinkpartikel erwiesen.

Nachfolgend werden bevorzugte Varianten des erfindungsgemäßen Verfahrens anhand der Zeichnung näher erläutert. Es zeigen:
- **Fig. 1**: eine Schnittdarstellung eines Halbleitersubstrats mit einer auf einem Siliziumkörper angeordneten Anschlussfläche im Ausgangszustand;
- **Fig. 2**: die in **Fig. 1** dargestellte Anschlussfläche nach einer elektrolytischen Beaufschlagung mit Zinkat;
- **Fig. 3**: die in **Fig. 2** dargestellte Anschlussfläche nach einer elektrolytischen Beaufschlagung mit Palladium;
- **Fig. 4**: die in **Fig. 3** dargestellte Anschlussfläche nach einer autokatalytischen Abscheidung von Nickel;
- **Fig. 5**: eine schematische Darstellung des Verfahrensablaufs zur Erzeugung einer erhöhten Kontaktmetallisierung auf einer Anschlussfläche basierend auf einer Bekeimung der Anschlussfläche;
- **Fig. 6 - 13**: verschiedene Verfahrensvarianten zur Durchführung der Bekeimung.

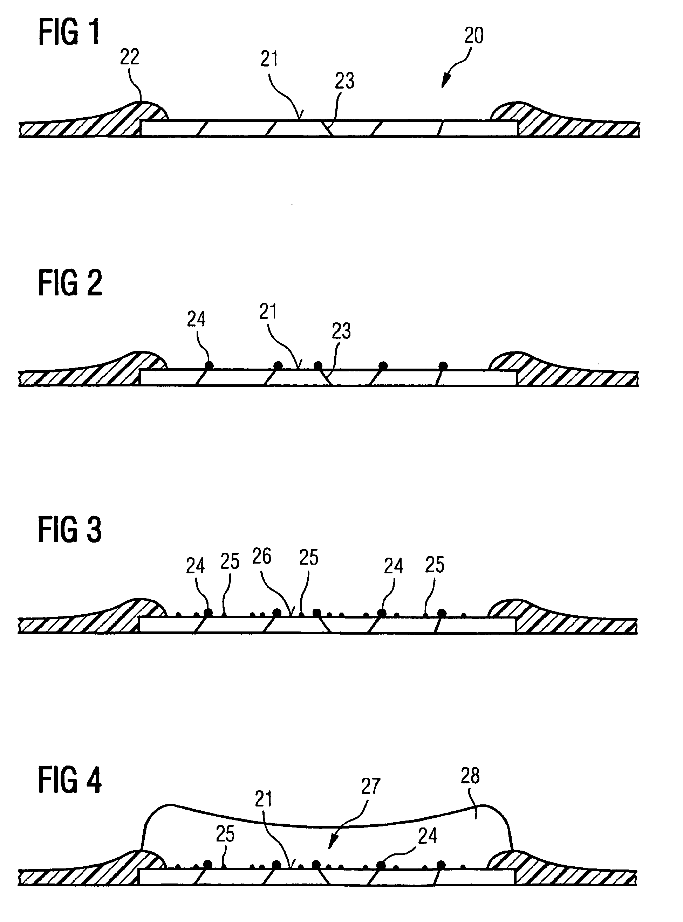

**Fig. 1** zeigt in einer Schnittdarstellung ein Halbleitersubstrat 20, wie beispielsweise einen Wafer oder einen Chip, mit einer hier aus Aluminium gebildeten Anschlussfläche 21, deren Umfangsrandbereich durch eine sich über die Oberfläche des Halbleitersubstrats 20 erstreckende Passivierungsschicht 22 abgedeckt ist. Es wird betont, dass die nachfolgenden Ausführungen betreffend Verfahrensvarianten zur Bekeimung der Anschlussfläche 21 nicht auf das hier beispielhaft ausgewählte Material, nämlich Aluminium, der Anschlussfläche 21 beschränkt sind.

**Fig. 2** zeigt die Anschlussfläche 21 nach einer elektrolytischen Beaufschlagung der Anschlussfläche 21 mit Zinkat. Deutlich zu erkennen ist, wie sich bevorzugt an Korngrenzen 23 des Anschlussflächenmaterials Zinkpartikel oder Zinkkörner 24 elektrolytisch abgeschieden haben. Ergebnis der elektrolytischen Abscheidung ist somit eine relativ grobe Verteilung von Zinkpartikeln 24 auf der Anschlussfläche 21.

**Fig. 3** zeigt die Anschlussfläche 21 nach einer der ersten elektrolytischen Beaufschlagung mit Zinkat nachfolgenden zweiten elektrolytischen Beaufschlagung mit Palladium. Ergebnis der Palladium-Beaufschlagung ist eine relativ feine Verteilung von Palladiumpartikeln oder Palladiumkörnern 25 auf den nach der Zinkat-Beaufschlagung freigebliebenen Zwischenflächen 26 der Anschlussfläche 21. Insgesamt wird durch die Beaufschlagung der Anschlussfläche 21 mit Zinkat und Palladium daher eine relativ fein verteilte Anordnung von Partikeln 24 und 25 erzeugt, die als Abscheidungskeime bei einer nachfolgenden autokatalytischen Beaufschlagung der Anschlussfläche 21 mit Nickel dienen.

Wie **Fig. 4** zeigt, bildet sich aufgrund einer durch das Zusammenwirken der Zinkpartikel 24 und der Palladiumpartikel 25 fein strukturierten und die Korngrenzen 23 des Anschlussflächenmaterials mit umfassenden Bekeimungsstruktur 27 in Verbindung mit der nachfolgenden autokatalytischen Nickel-Abscheidung eine gleichmäßige und mit ebenmäßiger Oberflächenmorphologie versehene Nickel-Beschichtung 28 auf der Anschlussfläche 21 aus.

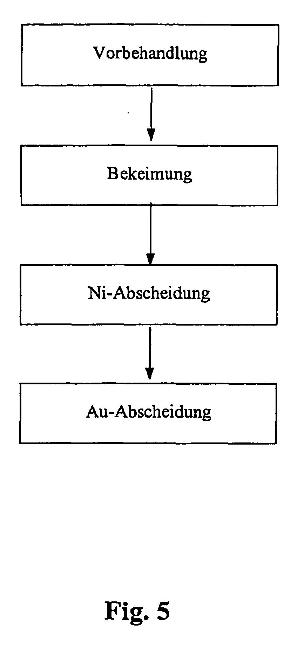

Wie in **Fig. 5** schematisch dargestellt, kann der in den **Fig. 1** bis **4** dargestellte Verfahrensablauf noch durch den der Bekeimung vorangehenden Verfahrensschritt einer Vorbehandlung der Anschlussfläche 21 im Sinne einer Reinigung zur Oxydschichtentfernung und einen der Ni-Abscheidung nachfolgenden Verfahrensschritt ergänzt werden, bei dem die auf der Anschlussfläche 21 erzeugte Nickelbeschichtung 28 noch mit einer ebenfalls im Wege der autokatalytischen Abscheidung hergestellten Au-Abscheidung versehen wird. Die Ni-Abscheidung bildet im vorliegenden Fall zusammen mit der Au-Abscheidung die Kontaktmetallisierung.

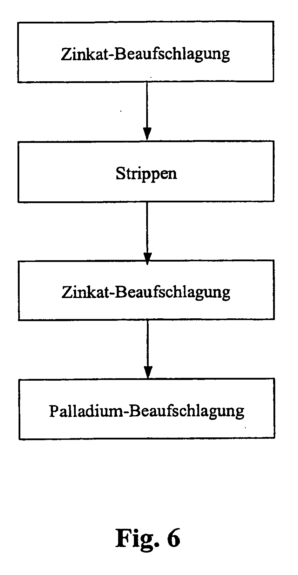

In den weiteren **Fig. 6** bis **13** sind bevorzugte Varianten bei der Durchführung der Bekeimung mittels einer elektrolytischen Beaufschlagung der Anschlussfläche 21 des Halbleitersubstrats 20 mit Zinkat und Palladium schematisch dargestellt.

Gemäß **Fig. 6** erfolgt zur Bekeimung der Anschlussfläche 21 zunächst eine Zinkat-Beaufschlagung, anschließend ein Strippen der durch die ZinkatBeaufschlagung auf der Anschlussfläche 21 elektrolytisch abgeschiedenen Zinkkörner, nachfolgend eine weitere Zinkat-Beaufschlagung und schließlich eine Palladium-Beaufschlagung.

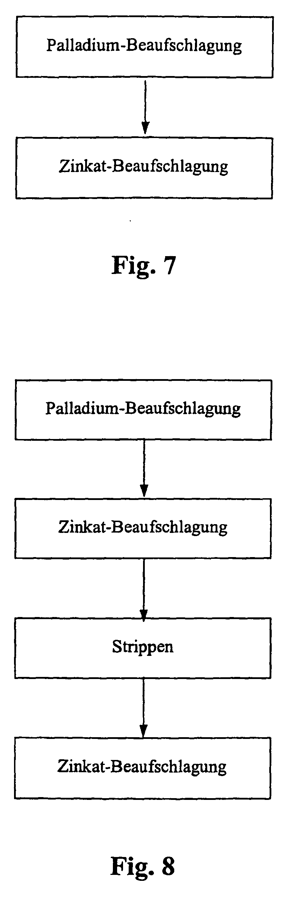

Gemäß **Fig. 7** erfolgt in einem ersten Bekeimungsschritt eine Palladium-Beaufschlagung und nachfolgend in einem zweiten Bekeimungsschritt eine Zikat-Beaufschlagung der Anschlussfläche 21.

Gemäß **Fig. 8** erfolgt in einem ersten Verfahrensschritt zur Bekeimung eine Palladium-Beaufschlagung der Anschlussfläche 21, nachfolgend eine erste Zinkat-Beaufschlagung, nachfolgend ein Strippen der in der ersten Zinkat-Beaufschlagung auf der Anschlussfläche 21 elektrolytisch abgeschiedenen Zinkkörner und schließlich eine zweite Zinkat-Beaufschlagung.

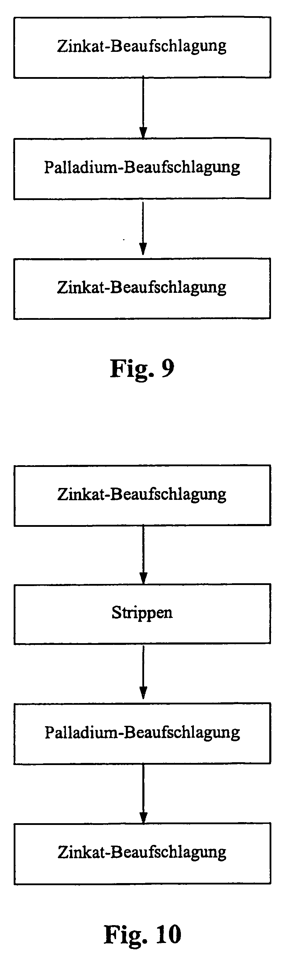

Gemäß **Fig. 9** erfolgt in einem ersten Verfahrensschritt zur Bekeimung eine Zinkat-Beaufschlagung der Anschlussfläche 21, anschließend eine Palladium-Beaufschlagung und schließlich eine zweite Zinkat-Beaufschlagung der Anschlussfläche 21.

Gemäß **Fig. 10** erfolgt in einem ersten Verfahrensschritt zur Bekeimung der Anschlussfläche 21 eine erste Zinkat-Beaufschlagung, anschließend ein Strippen der durch die erste Zinkat-Beaufschlagung elektrolytisch auf der Anschlussfläche 21 abgeschiedenen Zinkkörner, eine Palladium-Beaufschlagung und schließlich eine zweite Zinkat-Beaufschlagung der Anschlussfläche 21.

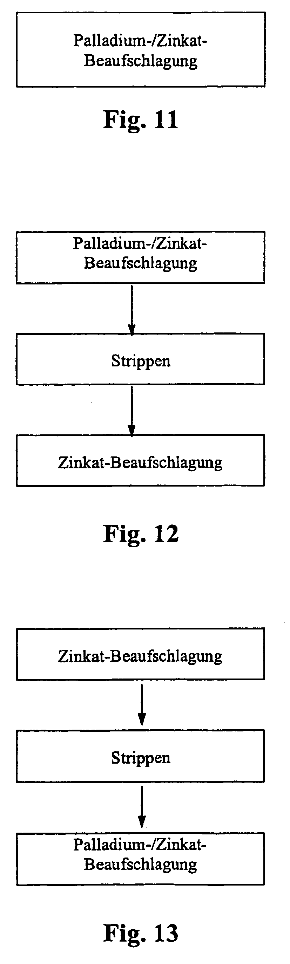

Gemäß **Fig. 11** erfolgt die Bekeimung der Anschlussfläche 21 in einem einzigen Verfahrensschritt mit einer Palladium/Zinkat-Beaufschlagung durch einen Elektrolyten, der sowohl Palladium- als auch Zinkat-Ionen aufweist.

Gemäß **Fig. 12** erfolgt in einem ersten Verfahrensschritt zur Bekeimung der Anschlussfläche 21 eine Palladium/Zinkat-Beaufschlagung, anschließend ein Strippen der durch die Palladium/Zinkat-Beaufschlagung auf der Anschlussfläche 21 elektrolytisch abgeschiedenen Zinkkörner und schließlich eine Zinkat-Beaufschlagung der Anschlussfläche 21.

Gemäß **Fig. 13** erfolgt zunächst in einem ersten Verfahrensschritt zur Bekeimung der Anschlussfläche 21 eine Zinkat-Beaufschlagung, anschließend ein Strippen der durch die Zinkat-Beaufschlagung auf der Anschlussfläche 21 elektrolytisch abgeschiedenen Zinkkörner und schließlich eine Palladium/Zinkat-Beaufschlagung der Anschlussfläche 21.

## Patentansprüche

1. Verfahren zur Herstellung eines Kontakthöckers auf einer Anschlussfläche eines Halbleitersubstrats, bei dem zur Ausbildung einer Trägermetallisierung (27) eine Bekeimung der Anschlussfläche (21) durch elektrolytische Beaufschlagung der Anschlussfläche (21) mit Zinkat erfolgt, derart, dass elektrolytisch auf der Anschlussfläche (21) abgeschiedene Zinkpartikel (24) als Keime für eine nachfolgend autokatalytisch auf der Anschlussfläche (21) abgeschiedene Kontaktmetallisierung (28) dienen, und neben der elektrolytischen Beaufschlagung mit Zinkat eine elektrolytische Beaufschlagung der Anschlussfläche (21) mit Palladium erfolgt, wobei
unter Ausbildung von zinkfreien Zwischenflächen (26) der Anschlussfläche eine relativ grobe Verteilung von Zinkpartikeln auf der Anschlussfläche erzeugt wird und eine relativ feine Verteilung von Palladiumpartikeln auf den zinkfreien Zwischenflächen erfolgt, die neben den Zinkpartikeln als Keime für die nachfolgend autokatalytisch auf der Anschlussfläche abgeschiedene Kontaktmetallisierung (28) dienen.

2. Verfahren nach Anspruch 1,
**dadurch gekenzeichnet,**
**dass** in einem Verfahrensschritt die elektrolytische Beaufschlagung der Anschlussfläche (21) mit Zinkat und in einem nachfolgenden Verfahrensschritt die elektrolytische Beaufschlagung der Anschlussfläche mit Palladium erfolgt.

3. Verfahren nach Anspruch 2,
**dadurch gekennzeichnet,**
**dass** vorangehend der Palladium-Beaufschlagung eine zumindest teilweise Entfernung der Zinkpartikel (24) mit anschließender erneuter Zinkat-Beaufschlagung erfolgt.

4. Verfahren nach Anspruch 1,
**dadurch gekennzeichnet,**
**dass** in einem Verfahrensschritt die elektrolytische Beaufschlagung der Anschlussfläche (21) mit Palladium und in einem nachfolgenden Verfahrensschritt die elektrolytische Beaufschlagung der Anschlussfläche (21) mit Zinkat erfolgt.

5. Verfahren nach Anspruch 4,
**dadurch gekennzeichnet,**
**dass** nachfolgend der Zinkat-Beaufschlagung eine zumindest teilweise Entfernung der Zinkpartikel (24) mit anschließender erneuter Zinkat-Beaufschlagung erfolgt.

6. Verfahren nach Anspruch 1,
**dadurch gekennzeichnet,**
**dass** in einem Verfahrensschritt eine erste elektrolytische Beaufschlagung der Anschlussfläche (21) mit Zinkat, in einem nachfolgenden Verfahrensschritt die elektrolytische Beaufschlagung der Anschlussfläche mit Palladium und in einem weiteren Verfahrensschritt eine zweite Zinkat-Beaufschlagung erfolgt.

7. Verfahren nach Anspruch 6,
**dadurch gekennzeichnet,**
**dass** nachfolgend der ersten Zinkat-Beaufschlagung und vorhergehend der Palladium-Beaufschlagung eine zumindest teilweise Entfernung der Zinkpartikel (24) erfolgt.

8. Verfahren nach Anspruch 1,
**dadurch gekennzeichnet,**
**dass** die elektrolytische Beaufschlagung der Anschlussfläche (21) mit Zinkat und die elektrolytische Beaufschlagung der Anschlussfläche mit Palladium in einem Verfahrensschritt erfolgt, derart, dass die Zinkat-Beaufschlagung gleichzeitig mit der Palladium-Beaufschlagung durch einen gemischten Elektrolyten erfolgt.

9. Verfahren nach Anspruch 8,
**dadurch gekennzeichnet,**
**dass** nachfolgend der Zinkat/Palladium-Beaufschlagung eine zumindest teilweise Entfernung der Zinkpartikel (24) mit anschließender erneuter Zinkat-Beaufschlagung der Anschlussfläche (21) erfolgt.

10. Verfahren nach Anspruch 8,
**dadurch gekennzeichnet,**
**dass** vorangehend der Zinkat/Palladium-Beaufschlagung eine Zinkat-Beaufschlagung der Anschlussfläche (21) mit anschließender zumindest teilweiser Entfernung der Zinkpartikel (24) erfolgt.

11. Verfahren nach einem der vorangehenden Ansprüche,
**dadurch gekennzeichnet,**
**dass** die zumindest teilweise Entfernung der Zinkpartikel (24) durch ein Strippen erfolgt.

## Claims

1. Method for manufacturing a bump on a terminal face of a semiconductor substrate, in which the terminal face (21) is nucleated to generate a basic metallization (27) through electrolytic coating of the terminal face (21) with zincate, in such a way that zinc particles (24) electrolytically deposited on the terminal face (21) serve as nuclei for an ensuing contact metallization (28) autocatalytically deposited on the terminal face (21), and in addition to the electrolytic coating with zincate, an electrolytic coating of the terminal face (21) with palladium takes place, wherein, while zinc-free intermediate surfaces (26) of the terminal face (21) are formed, a relatively coarse distribution of zinc particles on the terminal face is generated and there is a relatively fine distribution of palladium particles on the zinc-free intermediate surfaces which in addition to the zinc particles serve as nuclei for the contact metallization (28) subsequently autocatalytically deposited on the terminal face.

2. Method according to claim 1,
**characterized in that**
the electrolytic coating of the terminal face (21) with zincate takes place in one method step, and the electrolytic coating of the terminal face with palladium takes place in a subsequent method step.

3. Method according to claim 2,
**characterized in that**
palladium coating is preceded by at least a partial removal of the zinc particles (24) followed by renewed zincate coating.

4. The method according to claim 1,
**characterized in that**
the electrolytic coating of the terminal face (21) with palladium takes place in one method step, and the electrolytic coating of the terminal face (21) with zincate takes place in a subsequent method step.

5. The method according to claim 4,
**characterized in that**
zincate coating is followed by an at least partial removal of the zinc particles (24) followed by renewed zincate coating.

6. The method according to claim 1,
**characterized in that**
a first electrolytic coating of the terminal face (21) with zincate takes place in a first method step, the electrolytic coating of the terminal face with palladium takes place in a subsequent method step, and a second zincate coating takes place in another method step.

7. The method according to claim 6,
**characterized in that**
at least a partial removal of the zinc particles (24) takes place after the first zincate coating and before the palladium coating.

8. The method according to claim 1,
**characterized in that**
the electrolytic coating of the terminal face (21) with zincate and electrolytic coating of the terminal face with palladium take place in a single method step, in such a way that the zincate coating occurs simultaneously with the palladium coating via a mixed electrolyte.

9. The method according to claim 8,
**characterized in that**
the zincate/palladium coating is followed by at least a partial removal of the zinc particles (24), followed by renewed zincate coating of the terminal face (21).

10. The method according to claim 8,
**characterized in that**
the zincate/palladium coating is preceded by a zincate coating of the terminal face (21), followed by an at least partial removal of the zinc particles (24).

11. The method according to one of the preceding claims,
**characterized in that**
the at least partial removal of zinc particles (24) takes place via stripping.

## Revendications

1. Procédé de fabrication d'une bosse de contact sur une surface de connexion d'un substrat semi-conducteur, dans lequel afin de réaliser une métallisation de support (27), un ensemencement de la surface de connexion (21) a lieu par sollicitation électrolytique de la surface de connexion (21) avec du zincate, de telle sorte que des particules de zinc (24) déposées électrolytiquement sur la surface de connexion (21) servent de germes pour une métallisation de contact (28) déposée ensuite de manière auto-catalytique sur la surface de connexion (21) et, en dehors de la sollicitation électrolytique avec du zincate, une sollicitation électrolytique de la surface de connexion (21) avec du palladium a lieu, moyennant quoi en réalisant des surfaces intermédiaires (26) exemptes de zinc de la surface de connexion, une répartition relativement grossière de particules de zinc sur la surface de connexion est produite et une répartition relativement fine de particules de palladium sur les surface intermédiaires exemptes de zinc a lieu, lesquelles servent de germes, en dehors des particules de zinc, pour la métallisation de contact (28) déposée ultérieurement de manière auto-catalytique sur la surface de connexion.

2. Procédé selon la revendication 1,
**caractérisé en ce que**
dans une étape de procédé, la sollicitation électrolytique de la surface de connexion (21) avec du zincate a lieu et dans une étape de procédé suivante, la sollicitation électrolytique de la surface de connexion avec du palladium a lieu.

3. Procédé selon la revendication 2,
**caractérisé en ce que**
préalablement à la sollicitation avec du palladium, une élimination au moins partielle des particules de zinc (24) a lieu, suivie par une sollicitation avec du zincate renouvelée.

4. Procédé selon la revendication 1,
**caractérisé en ce que**
dans une étape de procédé, la sollicitation électrolytique de la surface de connexion (21) avec du palladium a lieu et dans une étape de procédé suivante, la sollicitation électrolytique de la surface de connexion (21) avec du zincate a lieu.

5. Procédé selon la revendication 4,
**caractérisé en ce que**
consécutivement à la sollicitation avec du zincate, une élimination au moins partielle des particules de zinc (24) a lieu, suivie par une sollicitation avec du zincate renouvelée.

6. Procédé selon la revendication 1,
**caractérisé en ce que**
dans une étape de procédé, une première sollicitation électrolytique de la surface de connexion (21) avec du zincate a lieu, dans une étape de procédé suivante, la sollicitation électrolytique de la surface de connexion avec du palladium a lieu et dans une étape de procédé supplémentaire, une deuxième sollicitation avec du zincate a lieu.

7. Procédé selon la revendication 6,
**caractérisé en ce que**
consécutivement à la première sollicitation avec du zincate et préalablement à la sollicitation avec du palladium, une élimination au moins partielle des particules de zinc (24) a lieu.

8. Procédé selon la revendication 1,
**caractérisé en ce que**
la sollicitation électrolytique de la surface de connexion (21) avec du zincate et la sollicitation électrolytique de la surface de connexion avec du palladium ont lieu dans une étape de procédé, de telle sorte que la sollicitation avec du zincate ait lieu simultanément à la sollicitation avec du palladium par un électrolyte mixte.

9. Procédé selon la revendication 8,
**caractérisé en ce que**
consécutivement à la sollicitation zincate/palladium, une élimination au moins partielle des particules de zinc (24) a lieu, suivie d'une sollicitation avec du zincate renouvelée de la surface de connexion (21).

10. Procédé selon la revendication 8,
**caractérisé en ce que**
préalablement à la sollicitation zincate/palladium, une sollicitation avec du zincate de la surface de connexion (21) a lieu, suivie d'une élimination au moins partielle des particules de zinc (24).

11. Procédé selon une des revendications précédentes,
**caractérisé en ce que**
l'élimination au moins partielle des particules de zinc (24) a lieu par un pelage.
